# EUROPÄISCHE PATENTSCHRIFT

(11) **EP 3 600 713 B1**
(45) Veröffentlichungstag und Bekanntmachung des Hinweises auf die Patenterteilung: **12.05.2021**
(21) Anmeldenummer: 18709469.3
(22) Anmeldetag: 01.03.2018
(51) Int. Cl.: B21F 99/00, F02P 7/067, G01P 3/481, H02N 11/00, H03K 17/97, B21F 7/00, B21F 9/00

(54) **VORRICHTUNG, INSBESONDERE MASCHINE, ZUM HERSTELLEN VON WIEGANDDRAHT AUS EINEM DRAHT, INSBESONDERE IMPULSDRAHTES, UND VERFAHREN ZUM BETREIBEN EINER VORRICHTUNG**
DEVICE, IN PARTICULAR MACHINE, FOR PRODUCING A WIEGAND WIRE FROM A WIRE, IN PARTICULAR A PULSE WIRE, AND METHOD FOR OPERATING A DEVICE
DISPOSITIF, EN PARTICULIER MACHINE, POUR LA FABRICATION DE FIL DE WIEGAND À PARTIR D'UN FIL, EN PARTICULIER D'UN FIL D'IMPULSION, ET PROCÉDÉ POUR LE FONCTIONNEMENT D'UN DISPOSITIF

(30) Priorität: 24.03.2017 DE 102017002939
(43) Veröffentlichungstag der Anmeldung: 05.02.2020
(73) Patentinhaber: SEW-EURODRIVE GmbH & Co. KG, 76646 Bruchsal (DE)
(72) Erfinder: SIMON, Olaf, 76646 Bruchsal / Untergrombach (DE); RÄDLE, Dennis, 76275 Ettlingen (DE); HOFFMANN, Julian, 67729 Sippersfeld (DE); FUCHS, Daniel, Simon, 76709 Kronau (DE)
(86) Internationale Anmeldenummer: PCT/EP2018/025055
(87) Internationale Veröffentlichungsnummer: WO 2018/171944

(56) Entgegenhaltungen:
- EP-A1- 0 710 963
- EP-A2- 0 085 140
- DE-A1- 2 819 305
- GB-A- 2 109 280
- JP-U- H04 137 600
- US-A- 3 892 118

## Beschreibung

Die Erfindung betrifft eine Vorrichtung, insbesondere Maschine, zum Herstellen von Wieganddraht aus einem Draht, insbesondere Impulsdrahtes, und ein Verfahren zum Betreiben einer Vorrichtung..

Es ist allgemein bekannt, dass Bohrmaschinen Spannfutter aufweisen, mit welchen jeweils ein Bohrer, also ein im Wesentlichen zylindrisches Bohrwerkzeug, aufnehmbar und kraftschlüssig verbindbar sind.

Aus der DE 28 19 305 C2 ist ein Verfahren zum Herstellen eines Wieganddrahtes bekannt.

**Aus der** US 3 892 118 A **ist ein Verfahren zum Herstellen einer bistabilen Magnetvorrichtung bekannt**.

Diese Druckschrift offenbart eine Vorrichtung zum Herstellen von Wieganddraht aus einem Draht, insbesondere Impulsdraht, wobei die Vorrichtung ein erstes Spannfutter, und ein zweites Spannfutter aufweist, wobei der Draht durch jedes der zwei Spannfutter geführt ist, so dass der Draht lösbar drehfest verbindbar mit den zwei Spannfuttern ist, insbesondere lösbar drehfest kraftschlüssig verbindbar mit den zwei Spannfuttern, wobei die Spannfutter in Drahtrichtung voneinander beabstandet sind, wobei das zweite Spannfutter drehbar gelagert ist, so dass ein Drahtbereich mit Torsion beaufschlagbar ist, wobei der Drahtbereich zwischen dem ersten Spannfutter und dem zweiten Spannfutter angeordnet ist.

**Aus der** EP 0 085 140 A2 **ist ein magnetischer Draht bekannt.**

**Aus der** EP 0 710 963 A1 **ist ein Puls-erzeugendes Element und ein Herstellverfahren hierfür bekannt.**

**Aus der** JP H04 137600 U **ist eine Maschine zum Herstellen eines Wieganddrahts mittels zweier Gummiwalzen und einer drehenden Trommel.**

**Aus der** GB 2 109 280 A **ist eine Kaltverarbeitung eines Metalldrahtes bekannt.**

Der Erfindung liegt daher die Aufgabe zugrunde, eine kostengünstige Herstellung eines Wieganddrahtes zu ermöglichen.

Erfindungsgemäß wird die Aufgabe bei der Vorrichtung nach den in Anspruch 1 und bei dem Verfahren nach den in Anspruch 10 angegebenen Merkmalen gelöst.

Wichtige Merkmale der Vorrichtung sind, dass die Vorrichtung, insbesondere Maschine, zum Herstellen von Wieganddraht aus einem Draht, insbesondere Impulsdrahtes, vorgesehen ist, wobei die Vorrichtung ein erstes Spannfutter, ein zweites Spannfutter und ein drittes Spannfutter aufweist, wobei der Draht durch jedes der drei Spannfutter geführt ist,
insbesondere so, dass der Draht lösbar drehfest verbindbar mit den drei Spannfuttern ist, insbesondere lösbar drehfest kraftschlüssig verbindbar mit den drei Spannfuttern,
wobei die Spannfutter in Drahtrichtung voneinander beabstandet sind, wobei das zweite Spannfutter in Drahtrichtung zwischen dem ersten und dem dritten Spannfutter angeordnet ist,
wobei das zweite Spannfutter drehbar gelagert ist, so dass ein erster Drahtbereich mit Torsion beaufschlagbar ist und ein zweiter Drahtbereich mit der umgekehrten Torsion beaufschlagbar ist,
wobei der erste Drahtbereich zwischen dem ersten Spannfutter und dem zweiten Spannfutter angeordnet ist,
wobei der zweite Drahtbereich zwischen dem dritten Spannfutter und dem zweiten Spannfutter angeordnet ist,
wobei der Abstand in Drahtrichtung zwischen dem ersten und dem zweiten Spannfutter mittels eines ersten Linearaktors steuerbar oder regelbar ist,
wobei der Abstand in Drahtrichtung zwischen dem zweiten und dem dritten Spannfutter mittels eines zweiten Linearaktors steuerbar oder regelbar ist.

Von Vorteil ist dabei, dass Spannfutter zum kraftschlüssigen halten des Drahtes verwendet werden. Somit ist der Draht durchfädelbar durch die Spannfutter und daher eine kontinuierliche Herstellung, also eine Herstellung des Wieganddrahtes ohne Abschneiden des Drahtes ermöglicht. Hierzu wird der durch die Spannfutter durchgefädelte Draht beim Betätigen, also Schließen, der Spannfutter kraftschlüssig gehalten. Mittels Drehung des zweiten Spannfutters, also des in Drahtrichtung zwischen dem ersten und dritten Spannfutter angeordneten Spannfutters, ist der zu bearbeitende Drahtbereich tordierbar. Dabei wird der Drahtbereich zwischen erstem und zweitem Spannfutter umgekehrt gedreht wie der zwischen zweitem und drittem Spannfutter angeordnete Drahtbereich.

Durch Erhöhen des Abstandes zwischen dem zweiten Spannfutter und erstem Spannfutter sowie durch Erhöhen des Abstandes zwischen dem zweiten Spannfutter und dritten Spannfutter wird zusätzlich zur durch die Drehung aufgebrachten Torsion eine Zugspannung auf die zu bearbeitende Drahtbereiche aufgebracht. Des Weiteren ist der Draht mit Strom beaufschlagbar, indem die Spannfutter elektrisch isoliert an der restlichen Vorrichtung befestigt sind. Somit ist das Anlegen einer elektrischen Spannung zwischen erstem und drittem Spannfutter vorsehbar zur Beaufschlagung des Drahtes mit einem Strom zur Erzeugung von Wärme.

Alternativ ist die Beaufschlagung des Drahtes mit Strom auch zwischen dem ersten und zweiten Spannfutter oder zwischen dem zweiten und dritten Spannfutter ausführbar.

Die Spannfutter sind ebenso wie der Draht metallisch und somit elektrisch leitfähig.

Nach Beendigung der Herstellung, also nach Herstellung der Wieganddrahteigenschaften in den beiden Drahtbereichen, werden die Spannfutter geöffnet und der Draht weiterbewegt, so dass ein neu zu bearbeitender Bereich des Drahtes zwischen das erste und dritte Spannfutter gefördert wird. Danach sind durch Schließen der Spannfutter die beschriebenen Herstellschritte wiederholbar.

Erstes und zweites Spannfutter werden jeweils durch Linearaktoren, insbesondere Spindelmotoren, also von einem jeweiligen Elektromotor angetriebene Spindeltriebe, hin- und herbewegt. Denn beim genannten Herstellschritt wird der jeweilige Abstand zum zweiten Spannfutter variiert oder erhöht und nach dem Fertigstellen des Drahtes werden erstes und drittes Spannfutter zurückgefahren in ihre Ausgangsposition. Ein Öffnen der Spannfutter ist nach Herstellung ausführbar.

Öffnen der Spannfutter werden erstes und zweites Spannfutter zurückgefahren in ihre Ausgangsposition.

Die Spannfutter sind entweder manuell oder mittels elektromotorischem Antrieb, insbesondere Riemenantrieb, betätigbar. Alternativ sind aber auch eine hydraulische, pneumatische oder elektrische Betätigung ausführbar.

Unter dem Begriff Wieganddraht wird bei der Erfindung stets auch Impulsdraht verstanden.

Bei einer vorteilhaften Ausgestaltung ist eine Spannungsquelle mit ihrem ersten Pol mit dem ersten Spannfutter und mit ihrem zweiten Pol mit dem dritten Spannfutter verbunden, insbesondere so dass der erste und der zweite Drahtbereich mit Strom beaufschlagbar sind,
wobei die drei Spannfutter jeweils elektrisch isoliert zur restlichen Vorrichtung angeordnet sind. Von Vorteil ist dabei, dass der Draht mit einem Strom beaufschlagbar ist. Alternativ ist die Beaufschlagung des Drahtes mit Strom auch zwischen dem ersten und zweiten Spannfutter oder zwischen dem zweiten und dritten Spannfutter ausführbar.

Bei einer vorteilhaften Ausgestaltung ist das erste Spannfutter in einer ersten Längungseinheit aufgenommen, das dritte Spannfutter in einer zweiten Längungseinheit aufgenommen ist,
das zweite Spannfutter in einer Torsionseinheit drehbar gelagert aufgenommen ist. Von Vorteil ist dabei, dass die Längungseinheiten von den Linearaktoren, insbesondere Spindelantrieben, bewegbar sind und somit auch die entsprechenden Spannfutter.

Bei einer vorteilhaften Ausgestaltung ist das dritte Spannfutter von einem Elektromotor, insbesondere von einem von einem zweiten Elektromotor angetriebenen Riementrieb, der Torsionseinheit drehbar. Von Vorteil ist dabei, dass die Torsion in einfacher Weise erzeugbar ist, wobei die Torsionseinheit auf einer Grundplatte der Vorrichtung elektrisch isoliert angeordnet und gehalten ist.

Bei einer vorteilhaften Ausgestaltung ist die erste Längungseinheit vom ersten Linearaktor relativ zur Torsionseinheit linear bewegbar, insbesondere in Drahtrichtung oder entgegengesetzt zur Drahtrichtung. Von Vorteil ist dabei, dass die Streckung in einfacher Weise erzeugbar ist, wobei die Längungseinheit auf einer Grundplatte der Vorrichtung elektrisch isoliert angeordnet und gehalten ist.

Bei einer vorteilhaften Ausgestaltung ist die zweite Längungseinheit vom zweiten Linearaktor relativ zur Torsionseinheit linear bewegbar, insbesondere entgegengesetzt zur Drahtrichtung oder in Drahtrichtung. Von Vorteil ist dabei, dass die Streckung in einfacher Weise erzeugbar ist, wobei die Längungseinheit auf einer Grundplatte der Vorrichtung elektrisch isoliert angeordnet und gehalten ist.

Bei einer vorteilhaften Ausgestaltung weist der erste Linearaktor einen von einem ersten Elektromotor angetriebenen Spindeltrieb auf, insbesondere wobei der erste Elektromotor mit einer Grundplatte fest verbunden ist, die Rotorwelle des Elektromotors drehfest mit einer Spindel verbunden ist, welche in Wirkverbindung mit einer Spindelmutter ist, welche fest mit der ersten Längungseinheit, insbesondere mit dem ersten Spannfutter verbunden ist. Von Vorteil ist dabei, dass der Antrieb in einfacher Weise kostengünstig ausführbar ist und der Linearaktor auf der Grundplatte anordenbar und haltbar ist.

Bei einer vorteilhaften Ausgestaltung weist der zweite Linearaktor einen von einem dritten Elektromotor angetriebenen Spindeltrieb auf, insbesondere wobei der dritte Elektromotor mit der Grundplatte fest verbunden ist, die Rotorwelle des dritten Elektromotors drehfest mit einer weiteren Spindel verbunden ist, welche in Wirkverbindung mit einer weiteren Spindelmutter ist, welche fest mit der zweiten Längungseinheit, insbesondere mit dem dritten Spannfutter verbunden ist. Von Vorteil ist dabei, dass der Antrieb in einfacher Weise kostengünstig ausführbar ist und der Linearaktor auf der Grundplatte anordenbar und haltbar ist.

Bei einer vorteilhaften Ausgestaltung ist die Torsionseinheit, insbesondere der zweite Motor, fest mit der Grundplatte verbunden, wobei der zweite Motor den Riemenantrieb antreibt, welcher das zweite Spannfutter betätigt und/oder das zweite Spannfutter zur Erzeugung von Torsion im jeweils zu bearbeitenden Drahtbereich dreht. Von Vorteil ist dabei, dass die Vorrichtung eine stabile Maschine ist. Außerdem sind auf der Grundplatte Halterungen befestigbar, welche drehbar gelagerte Rollen aufweisen. Dabei ist eine erste Rolle für den noch nicht bearbeiteten Bereich des Drahtes vorgesehen und eine zweite Rolle für den bearbeiteten Bereich des Drahtes, also den hergestellten Wieganddraht. Das Aufwickeln auf die zweite Rolle ermöglicht, eine große Menge von hergestelltem Produkt kompakt zu lagern. Vor der Verwendung wird dann der Wieganddraht von der zweiten Rolle abgewickelt und die benötigten Drahtabschnitte abgeschnitten. Aus jedem der derart abgeschnittenen Drahtstücke lässt sich dann ein Drahtstück für einen Wiegandsensor herstellen.

Bei einer vorteilhaften Ausgestaltung weist die Vorrichtung einen Sensor zur Erfassung zumindest einer magnetischen Größe auf. Von Vorteil ist dabei, dass der Draht durch eine Entmagnetisierungseinheit entmagnetisierbar ist und/oder die Drahtqualität kontinuierlich überwachbar ist und/oder dass die durch eine Entmagnetisierungseinheit erreichte Entmagnetisierung überwachbar ist.

Bei einer vorteilhaften Ausgestaltung weist die Vorrichtung mindestens einen Sensor zur Erfassung einer Zugspannung in einem zu bearbeitenden Drahtbereich auf,
insbesondere wobei der Sensor zur Erfassung der Zugspannung in der ersten und/oder zweiten Längungseinheit angeordnet ist. Von Vorteil ist dabei, dass ein kontrollierter, also gesteuerter Wert an Zugspannung erzeugbar ist.

Bei einer vorteilhaften Ausgestaltung besteht **der Draht aus einem Material, welches Kobalt, Eisen und Vanadium enthält,**
**insbesondere wobei der Anteil von Vanadium zwischen 5 % und 20 % beträgt, wobei der Anteil von Kobalt zwischen 40% und 65% beträgt und wobei der Anteil von Eisen zwischen 35% und 60% beträgt.** Von Vorteil ist dabei, dass ein Wieganddraht hoher Qualität und für lange Standzeit herstellbar ist.

Wichtige Merkmale bei dem Verfahren zum Betreiben einer Vorrichtung sind, dass der zu bearbeitende Bereich des Drahtes durch drei Spannfutter geführt wird,
danach die Spannfutter betätigt, insbesondere geschlossen, werden, so dass der Draht kraftschlüssig mit den Spannfuttern gehalten wird,
danach das zweite Spannfutter gedreht wird, wobei die Drehachse koaxial zur Drahtrichtung ausgerichtet ist
und der Abstand zwischen dem ersten Spannfutter und dem zweiten Spannfutter vergrößert wird sowie der Abstand zwischen dem dritten Spannfutter und dem zweiten Spannfutter vergrößert wird,
wobei zwischen erstem und drittem Spannfutter der Draht mit einem Strom beaufschlagt wird,
danach die Spannfutter geöffnet werden und der Draht weiterbewegt wird, so dass ein neu zu bearbeitender Bereich des Drahtes durch drei Spannfutter geführt wird und die genannten Verfahrensschritten wiederholt werden.

Alternativ ist die Beaufschlagung des Drahtes mit Strom auch zwischen dem ersten und zweiten Spannfutter oder zwischen dem zweiten und dritten Spannfutter ausführbar.

Von Vorteil ist dabei, dass eine kontinuierliche Herstellung, also eine Herstellung ohne Bearbeiten von einzelnen Drahtstücken ausführbar ist. Der Draht wird quasi in einem Stop and Go Verfahren durch die Spannfutter geführt und dabei bearbeitet. Die bearbeiteten Bereiche sind am Draht vorhanden und auf der zweiten Rolle aufgewickelt.

Bei einer vorteilhaften Ausgestaltung wird der aus dem dritten Spannfutter herausgeführte Drahtbereich entmagnetisiert. Von Vorteil ist dabei, dass ein definierter auslieferzustand einhaltbar ist.

Somit ist ein Wieganddraht kontinuierlich und in hohe Güte herstellbar.

Weitere Vorteile ergeben sich aus den Unteransprüchen.

Die Erfindung wird nun anhand von Abbildungen näher erläutert:
In der Figur 1 ist eine Anlage zum Herstellen von Wieganddraht, also Impulsdraht, in Schrägansicht dargestellt.
In der Figur 2 ist eine zugehörige Seitenansicht gezeigt.
In der Figur 3 ist die Funktionsweise der Anlage schematisch skizziert.

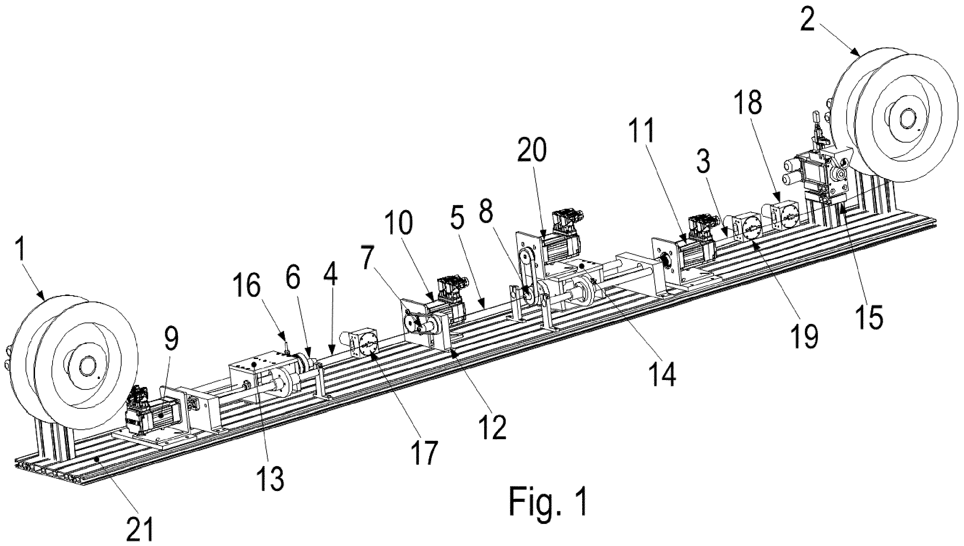

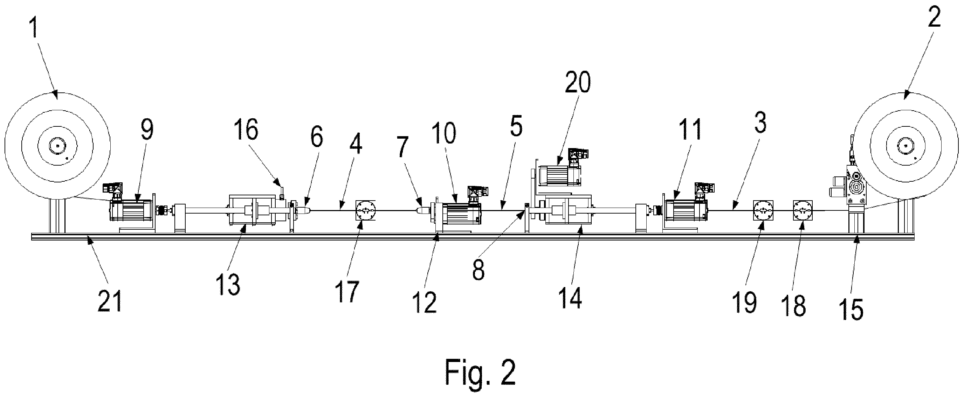

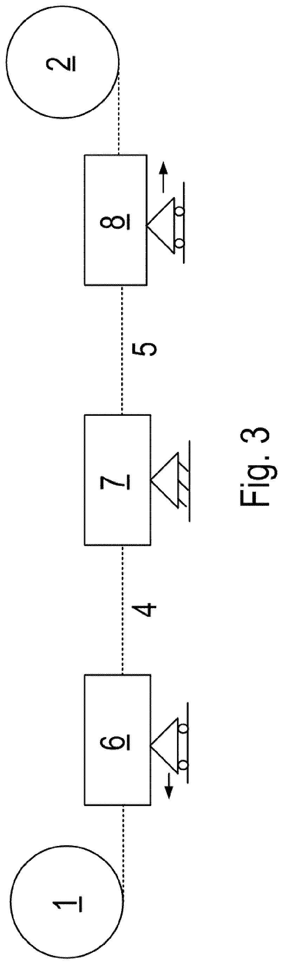

Wie in Figur 3 schematisch und in den Figuren 1 und 2 konkret gezeigt, weist die Anlage eine erste Rolle 1 auf, auf welcher der noch unbearbeitete Bereich eines Drahtes 3 als Rohdraht aufgewickelt angeordnet ist.

Der zu bearbeitende Bereich ist durch die Anlage geführt und der jeweils fertig bearbeitete Bereich des Drahtes 3 ist auf einer zweiten drehbar gelagerten Rolle 2 aufgewickelt.

Der zu bearbeitende Bereich des Drahtes 3 ist an drei voneinander in Drahtrichtung beabstandeten Stellen mit einem jeweiligen Spannfutter (6, 7, 8) kraftschlüssig verbunden. Die Spannfutter (6, 7, 8) halten an den Stellen den Draht 3, wobei bei der Bearbeitung das in Drahtrichtung mittlere Spannfutter 7 gedreht wird, wobei die Drehachse parallel und/oder koaxial zum Draht 3 ausgerichtet ist. Diese relativ zu den Beiden andere Spannfuttern (6, 8) ausgeführte Drehbewegung erzeugt einen ersten Drahtbereich 4, welcher im entgegengesetzten Drehsinn gedreht ist im Vergleich zu einem zweiten Drahtbereich 5.

Dabei ist der erste Drahtbereich 3 zwischen dem mittleren Spannfutter 7 und dem näher an der Rolle 1 angeordneten ersten Spannfutter 6. Entsprechend ist der zweite Drahtbereich zwischen dem mittleren Spannfutter 7 und dem dritten Spannfutter 8 angeordnet.

Das erste Spannfutter 6 ist zum mittleren Spannfutter 7 relativ bewegbar, insbesondere längs der Drahtrichtung. Somit ist der erste Drahtbereich 4 streckbar, also seine Länge veränderbar.

Ebenso ist das dritte Spannfutter 8 zum mittleren Spannfutter 7 relativ bewegbar, insbesondere längs der Drahtrichtung. Somit ist der zweite Drahtbereich 5 streckbar, also seine Länge veränderbar.

Das mittlere Spannfutter 7 ist fest verbunden mit einer Grundplatte, also dem Maschinenbett. Mit dieser Grundplatte sind auch Drehlager der Rollen 1 und 2 verbunden sowie Linearaktoren zur Verschiebung des ersten und dritten Spannfutters (6, 8).

Die Herstellung des Wieganddrahtes wird also in den folgenden Schritten ausgeführt.

Zunächst wird der zu bearbeitende Bereich des Drahtes 3 mit den Spannfutter 6, 7 und 8 kraftschlüssig verbunden. Danach wird die Drehung des mittleren Spannfutters 7 zur Erzeugung der Torsion im ersten und zweiten Drahtbereich (4, 5) ausgeführt und das erste und dritte Spannfutter (6, 8) jeweils vom mittleren Spannfutter 7 wegbewegt zur Erzeugung einer Streckung, also Längung.

Für die Linearbewegung des ersten Spannfutters 6 ist ein erster Motor 9 auf der Grundplatte 21 angeordnet, welcher eine Spindel, insbesondere Kugelrollspindel, antreibt, deren Gewindebereich in Wirkverbindung mit einer Spindelmutter ist, die mit dem ersten Spannfutter 6 in der ersten Längungseinheit 13 aufgenommen und somit fest verbunden ist. Somit wird durch Drehbewegung des ersten Motors 9 die ersten Längungseinheit 13 parallel zur Drahtrichtung hin- oder herverschiebbar. Außerdem ist ein Sensor 16 zur Erfassung der Zugskraft oder Zugspannung des zu bearbeitenden Bereichs des Drahtes 3 an der ersten Längungseinheit 13 angeordnet.

Für die Linearbewegung des zweiten Spannfutters 6 ist ein dritter Motor 11 auf der Grundplatte 21 angeordnet, welcher eine weitere Spindel, insbesondere ebenfalls Kugelrollspindel, antreibt, deren Gewindebereich in Wirkverbindung mit einer Spindelmutter ist, die mit dem dritten Spannfutter 8 in der zweiten Längungseinheit 14 aufgenommen und somit fest verbunden ist. Somit wird durch Drehbewegung des dritten Motors 11 die zweite Längungseinheit 14 parallel zur Drahtrichtung hin- oder herverschiebbar.

### Das erste Spannfutter 6 ist manuell betätigbar.

Das dritte Spannfutter 8 ist über einen Riementrieb betätigbar, welcher von einem vierten Motor 20 antreibbar ist. In einer ersten Drehrichtung der Rotorwelle des vierten Motors 20 wird das dritte Spannfutter 8 geöffnet und bei entgegengesetzter Drehrichtung der Rotorwelle geschlossen.

Das zweite, also mittlere, Spannfutter 7 wird ebenfalls über einen Riementrieb von einem zweiten Motor 10 betätigt. Dabei ist der Motor 10 nicht nur Antrieb zum Öffnen oder Schließen des zweiten Spannfutters 7, sondern auch zur Erzeugung der Torsion.

Die aus dem zweiten Motor 10 und dem zweiten Spannfutter 7 gebildete Torsionseinheit 12 ist elektrisch isoliert aber fest verbunden mit der Grundplatte 21.

In einem zusätzlichen Herstellschritt wird der zu bearbeitende Bereich des Drahtes mit einem Strom beaufschlagt, so dass ein vorgesehener Temperaturbereich erreicht wird. Hierzu sind die drei Spannfutter (6, 7, 8) sowie die Rollen 1 und 2 elektrisch isoliert von der Grundplatte angeordnet. Somit genügt es, zwischen dem metallisch ausgeführten ersten und dritten Spannfutter 6 und 8 eine Spannung anzulegen, so dass durch die beiden Drahtbereiche (4, 5) ein Strom fließt. Hierzu weist der Draht 3 einen derartigen Widerstand auf, dass die entstehende Ohm'sche Wärme den vorgesehenen Temperaturbereich des Drahtes 3 erreichbar machen.

Bei einem anderen erfindungsgemäßen Ausführungsbeispiel wird die Spannung zwischen dem ersten und zweiten Spannfutter angelegt oder zwischen dem zweiten und dritten Spannfutter angelegt.

Wie in den Figuren gezeigt, wird nach der Ausführung der genannten Herstellschritte der Draht 3 zur zweiten Rolle 2 hinbewegt und dort aufgewickelt. Hierzu ist eine Drahtvorschubseinheit 15 vorgesehen, welche die Rolle 2 antreibt und somit ein Aufwickeln bewirkt. Dabei wird der bearbeitete Bereich entlang einer Entmagnetisierungseinheit 19 und entlang Sensoren 17 und 19 bewegt.

Mittels der Maschine ist also ein Draht 3 mit Torsion und Längenstreckung bei hoher Temperatur herstellbar. Auf diese Weise ist aus dem Rohdraht ein Wieganddraht erzeugt, also ein Impulsdraht. Die bearbeitenden Bereiche des Drahtes 3 sind auf der zweiten Rolle 2 aufgewickelt und bei der späteren Verwendung abwickelbar und abschneidbar. Beispielsweise sind Drahtbereiche (4, 5) von 10 cm ohne besonderen Aufwand herstellbar.

Sobald der bearbeitete Bereich aufgewickelt ist, werden die Spannfutter (6, 7, 8) wird verengt und somit ein neu zu bearbeitender Bereich des Drahtes 3 mit den Spannfuttern (6, 7, 8) wieder kraftschlüssig verbunden. Die Herstellschritte sind sodann wiederholbar.

Somit ist ein quasikontinuierliches Herstellen ermöglicht, indem sozusagen immer schrittweise ein jeweils neuer, zu bearbeitender Bereich zwischen das erste Spannfutter 6 und das dritte Spannfutter 8 gebracht wird.

Beim Vorbeifahren des hergestellten Wieganddrahtes an der Entmagnetisierungseinheit 19 und nachfolgend am Sensor 18 ist die Qualität überprüfbar.

Der Draht ist aus einem Material gefertigt, welches einen Anteil von Vanadium zwischen 5 % und 20 %, einen Anteil von Kobalt zwischen 40% und 65% und einen Anteil von Eisen zwischen 35% und 60% aufweist.

Die Antriebe werden von einer zentralen Steuerung gesteuert, indem dieses jeweilige Streck- und Torsionsverläufe vorgibt. Insbesondere ist aber auch die Drahtlänge des hergestellten Drahtes Steuerbar und die Zugspannung und somit auch die Drahtdehnung steuerbar. Des Weiteren ist auch der zeitliche Verlauf der Torsion von der Steuerung vorgebbar, insbesondere die Anzahl der Umdrehungen beim Tordieren, Drehrichtung und Winkelgeschwindigkeit beim Tordieren des Drahtes. Ebenso sind durch die Steuerung die elektrischen Spannungsverläufe zur Bestromung des Drahtes vorgebbar. Auf diese Weise ist sogar ein vollautomatisches Erreichen eines Optimums von Werten elektrischer und magnetischer Eigenschaften des Drahtes ermöglicht. Mittels des Sensors 16 zur Erfassung der Zugkraft im Draht ist auch ein Drahtbruch sofort erkennbar. Außerdem ist mittels des Sensors 16 die Zugkraft während der Herstellung überwachbar und somit auch die Rohdrahtqualität überwachbar und/oder Materialfehler erkennbar.

Bei einem weiteren erfindungsgemäßen Ausführungsbeispiel ist das erste Spannfutter 6 manuell betätigbar.

### Bezugszeichenliste

1 Rolle für Rohdraht
2 Rolle für Wieganddraht
3 Draht
4 erster Drahtbereich
5 zweiter Drahtbereich
6 erstes Spannfutter
7 zweites Spannfutter
8 drittes Spannfutter
9 erster Motor
10 zweiter Motor
11 dritter Motor
12 Torsionseinheit
13 erste Längungseinheit
14 zweite Längungseinheit
15 Drahtvorschubseinheit
16 Zugkraftsensor
17 Sensor
18 Sensor
19 Entmagnetisierungseinheit
20 vierter Motor
21 Grundplatte, metallisch

## Patentansprüche

1. Vorrichtung, insbesondere Maschine, zum Herstellen von Wieganddraht aus einem Draht (3), insbesondere aus einem Impulsdraht, wobei die Vorrichtung ein erstes Spannfutter (6), ein zweites Spannfutter (7) und ein drittes Spannfutter (8) aufweist, wobei der Draht (3) durch jedes der drei Spannfutter (6, 7, 8) geführt ist,
insbesondere so dass der Draht (3) lösbar drehfest verbindbar mit den drei Spannfuttern ist, insbesondere lösbar drehfest kraftschlüssig verbindbar mit den drei Spannfuttern,
wobei die Spannfutter (6, 7, 8) in Drahtrichtung voneinander beabstandet sind, wobei das zweite Spannfutter (7) in Drahtrichtung zwischen dem ersten und dem dritten Spannfutter (8) angeordnet ist,
wobei das zweite Spannfutter (7) drehbar gelagert ist, so dass ein erster Drahtbereich mit Torsion beaufschlagbar ist und ein zweiter Drahtbereich mit der umgekehrten Torsion beaufschlagbar ist,
wobei der erste Drahtbereich zwischen dem ersten Spannfutter (6) und dem zweiten Spannfutter (7) angeordnet ist,
wobei der zweite Drahtbereich zwischen dem dritten Spannfutter (8) und dem zweiten Spannfutter (7) angeordnet ist,
wobei der Abstand in Drahtrichtung zwischen dem ersten und dem zweiten Spannfutter (6, 7) mittels eines ersten Linearaktors steuerbar oder regelbar ist,
wobei der Abstand in Drahtrichtung zwischen dem zweiten und dem dritten Spannfutter (8, 7) mittels eines zweiten Linearaktors steuerbar oder regelbar ist.

2. Vorrichtung nach **Anspruch 1,**
**dadurch gekennzeichnet, dass**
die drei Spannfutter (8, 7, 6) jeweils elektrisch isoliert zur restlichen Vorrichtung angeordnet sind,
- wobei eine Spannungsquelle mit ihrem ersten Pol mit dem ersten Spannfutter (6) und mit ihrem zweiten Pol mit dem dritten Spannfutter (8) verbunden ist, insbesondere so dass der erste und der zweite Drahtbereich mit Strom beaufschlagbar sind,
- oder wobei eine Spannungsquelle mit ihrem ersten Pol mit dem ersten Spannfutter und mit ihrem zweiten Pol mit dem zweien Spannfutter (7) verbunden ist, insbesondere so dass der erste Drahtbereich mit Strom beaufschlagbar sind,
- oder wobei eine Spannungsquelle mit ihrem zweiten Pol mit dem zweiten Spannfutter (7) und mit ihrem zweiten Pol mit dem dritten Spannfutter (8) verbunden ist, insbesondere so dass der zweite Drahtbereich mit Strom beaufschlagbar sind.

3. Vorrichtung nach einem der vorangegangenen Ansprüche,
**dadurch gekennzeichnet, dass**
das erste Spannfutter (6) in einer ersten Längungseinheit (13) aufgenommen ist,
das dritte Spannfutter (8) in einer zweiten Längungseinheit (14) aufgenommen ist,
das zweite Spannfutter (7) in einer Torsionseinheit (12) drehbar gelagert aufgenommen ist.

4. Vorrichtung nach einem der vorangegangenen Ansprüche,
**dadurch gekennzeichnet, dass**
das dritte Spannfutter (8) von einem Elektromotor (9), insbesondere von einem von einem zweiten Elektromotor (10) angetriebenen Riementrieb, der Torsionseinheit (12) drehbar ist.

5. Vorrichtung nach einem der vorangegangenen Ansprüche,
**dadurch gekennzeichnet, dass**
die erste Längungseinheit (13) vom ersten Linearaktor relativ zur Torsionseinheit (12) linear bewegbar ist, insbesondere in Drahtrichtung oder entgegengesetzt zur Drahtrichtung, und/oder dass
die zweite Längungseinheit (14) vom zweiten Linearaktor relativ zur Torsionseinheit (12) linear bewegbar ist, insbesondere entgegengesetzt zur Drahtrichtung oder in Drahtrichtung.

6. Vorrichtung nach einem der vorangegangenen Ansprüche,
**dadurch gekennzeichnet, dass**
der erste Linearaktor einen von einem ersten Elektromotor (9) angetriebenen Spindeltrieb aufweist, insbesondere wobei der erste Elektromotor (9) mit einer Grundplatte (21) fest verbunden ist, die Rotorwelle des Elektromotors drehfest mit einer Spindel verbunden ist, welche in Wirkverbindung mit einer Spindelmutter ist, welche fest mit der ersten Längungseinheit (13), insbesondere mit dem ersten Spannfutter (6) verbunden ist,
und/oder dass
der zweite Linearaktor einen von einem dritten Elektromotor (11) angetriebenen Spindeltrieb aufweist, insbesondere wobei der dritte Elektromotor (11) mit der Grundplatte (21) fest verbunden ist, die Rotorwelle des dritten Elektromotors (11) drehfest mit einer weiteren Spindel verbunden ist, welche in Wirkverbindung mit einer weiteren Spindelmutter ist, welche fest mit der zweiten Längungseinheit (14), insbesondere mit dem dritten Spannfutter (8) verbunden ist.

7. Vorrichtung nach einem der vorangegangenen Ansprüche,
**dadurch gekennzeichnet, dass**
die Torsionseinheit (12), insbesondere der zweite Motor (10), fest mit der Grundplatte (21) verbunden ist, wobei der zweite Motor (10) den Riemenantrieb antreibt, welcher das zweite Spannfutter (7) betätigt und/oder das zweite Spannfutter (7) zur Erzeugung von Torsion im jeweils zu bearbeitenden Drahtbereich dreht.

8. Vorrichtung nach einem der vorangegangenen Ansprüche,
**dadurch gekennzeichnet, dass**
die Vorrichtung einen Sensor (17, 18) zur Erfassung zumindest einer magnetischen Größe aufweist.

9. Vorrichtung nach einem der vorangegangenen Ansprüche,
**dadurch gekennzeichnet, dass**
die Vorrichtung einen Sensor (17, 18) zur Erfassung einer Zugspannung in einem zu bearbeitenden Drahtbereich aufweist,
insbesondere wobei der Sensor (17, 18) zur Erfassung der Zugspannung in der ersten und/oder zweiten Längungseinheit (14) angeordnet ist.

10. Verfahren zum Betreiben einer Vorrichtung nach einem der vorangegangenen Ansprüche,
**dadurch gekennzeichnet, dass**
der zu bearbeitende Bereich des Drahtes (3) durch drei Spannfutter (8) geführt wird, danach die Spannfutter (6, 7, 8) betätigt, insbesondere geschlossen, werden, so dass der Draht (3) kraftschlüssig mit den Spannfuttern gehalten wird,
danach das zweite Spannfutter (8) gedreht wird, wobei die Drehachse koaxial zur Drahtrichtung ausgerichtet ist
und der Abstand zwischen dem ersten Spannfutter (6) und dem zweiten Spannfutter (7) verändert, insbesondere vergrößert, wird sowie der Abstand zwischen dem dritten Spannfutter (8) und dem zweiten Spannfutter (7) verändert, insbesondere vergrößert, wird, wobei zwischen zwei der Spannfutter (6, 7, 8) der Draht (3) mit einem Strom beaufschlagt wird, insbesondere zwischen dem ersten und dritten Spannfutter (6, 8) oder zwischen dem ersten und zweiten Spannfutter (6, 7) oder zwischen dem zweiten und dritten Spannfutter (8, 7),
danach die Spannfutter (8, 7, 6) geöffnet werden und der Draht (3) weiterbewegt wird, so dass ein neu zu bearbeitender Bereich des Drahtes (3) durch drei Spannfutter (8, 7, 6) geführt wird und die genannten Verfahrensschritten wiederholt werden.

11. Verfahren nach Anspruch 10,
**dadurch gekennzeichnet, dass**
der aus dem dritten Spannfutter (8) herausgeführte Drahtbereich entmagnetisiert wird.

12. Verfahren nach Anspruch 10 oder 11,
**dadurch gekennzeichnet, dass**
die Zugkraft des Drahtes (3) im ersten und/oder zweiten Drahtbereich insbesondere mittels eines Zugkraftsensors (16) erfasst wird.

13. Verfahren nach Anspruch 10, 11 oder 12,
**dadurch gekennzeichnet, dass**
Werte physikalischer Größen, insbesondere Werte elektrischer und magnetischer Größen, des Drahtes (3) bestimmt werden, insbesondere mittels Sensoren, und davon abhängig die Antriebe derart angesteuert werden, dass ein Optimum von Werten automatisiert erreicht wird.

## Claims

1. A device, in particular a machine, for manufacturing Wiegand wire from a wire (3), in particular from a pulse wire,
wherein
the device has a first chuck (6), a second chuck (7) and a third chuck (8), wherein the wire (3) is guided through each of the three chucks (6, 7, 8),
in particular so that the wire (3) is releasably connectable in a rotationally-fixed manner to the three chucks, in particular releasably connectable in a rotationally-fixed and force-locked manner to the three chucks,
wherein the chucks (6, 7, 8) are spaced apart from one another in the wire direction, wherein the second chuck (7) is arranged between the first and the third chuck (8) in the wire direction, wherein the second chuck (7) is rotatably mounted, so that a first wire region can be acted upon by torsion and a second wire region can be acted upon by the opposite torsion,
wherein the first wire region is arranged between the first chuck (6) and the second chuck (7), wherein the second wire region is arranged between the third chuck (8) and the second chuck (7),
wherein the spacing in the wire direction between the first and the second chuck (6, 7) is controllable or regulatable by means of a first linear actuator,
wherein the spacing in the wire direction between the second and the third chuck (8, 7) is controllable or regulatable by means of a second linear actuator.

2. A device according to claim 1,
**characterised in that**
the three chucks (8, 7, 6) are each arranged electrically insulated from the remainder of the device,
- wherein the first pole of a voltage source is connected to the first chuck (6) and its second pole is connected to the third chuck (8), in particular so that the first and the second wire region can be acted upon by current,
- or wherein the first pole of a voltage source is connected to the first chuck and its second pole is connected to the second chuck (7), in particular so that the first wire region can be acted upon by current,
- or wherein the second pole of a voltage source is connected to the second chuck (7) and is connected to the third chuck (8), in particular so that the second wire region can be acted upon by current.

3. A device according to any one of the preceding claims,
**characterised in that**
the first chuck (6) is received in a first elongation unit (13), the third chuck (8) is received in a second elongation unit (14), the second chuck (7) is received in a torsion unit (12) in a rotatably mounted manner.

4. A device according to any one of the preceding claims,
**characterised in that**
the third chuck (8) is rotatable by an electric motor (9), in particular by a belt drive driven by a second electric motor (10), of the torsion unit (12).

5. A device according to any one of the preceding claims,
**characterised in that**
the first elongation unit (13) is linearly movable relative to the torsion unit (12) by the first linear actuator, in particular in the wire direction or opposite to the wire direction,
and/or **in that**
the second elongation unit (14) is linearly movable relative to the torsion unit (12) by the second linear actuator, in particular opposite to the wire direction or in the wire direction.

6. A device according to any one of the preceding claims,
**characterised in that**
the first linear actuator has a spindle drive driven by a first electric motor (9), in particular wherein the first electric motor (9) is securely connected to a base plate (21), the rotor shaft of the electric motor is connected in a rotationally-fixed manner to a spindle which is in an operative connection with a spindle nut which is securely connected to the first elongation unit (13), in particular to the first chuck (6),
and/or **in that**
the second linear actuator has a spindle drive driven by a third electric motor (11), in particular wherein the third electric motor (11) is securely connected to the base plate (21), the rotor shaft of the third electric motor (11) is connected in a rotationally-fixed manner to a further spindle which is in an operative connection with a further spindle nut which is securely connected to the second elongation unit (14), in particular to the third chuck (8).

7. A device according to any one of the preceding claims,
**characterised in that**
the torsion unit (12), in particular the second motor (10), is securely connected to the base plate (21), wherein the second motor (10) drives the belt drive which actuates the second chuck (7) and/or rotates the second chuck (7) to produce torsion in the wire region to be worked in each case.

8. A device according to any one of the preceding claims,
**characterised in that**
the device has a sensor (17, 18) to detect at least one magnetic parameter.

9. A device according to any one of the preceding claims,
**characterised in that**
the device has a sensor (17, 18) to detect tensile stress in a wire region to be worked, in particular wherein the sensor (17, 18) to detect the tensile stress is arranged in the first and/or second elongation unit (14).

10. A method of operating a device according to any one of the preceding claims,
**characterised in that**
that region of the wire (3) to be worked is guided through three chucks (8),
thereafter the chucks (6, 7, 8) are actuated, in particular closed, so that the wire (3) is held in a force-locked manner by the chucks,
thereafter the second chuck (8) is rotated, wherein the rotational axis is oriented coaxially with the wire direction
and the spacing between the first chuck (6) and the second chuck (7) is altered, in particular increased, and the spacing between the third chuck (8) and the second chuck (7) is altered, in particular increased, wherein the wire (3) is acted up by a current between two of the chucks (6, 7, 8), in particular between the first and third chuck (6, 8) or between the first and second chuck (6, 7) or between the second and third chuck (8, 7),
thereafter the chucks (8, 7, 6) are opened and the wire (3) is advanced, so that a region of the wire (3) to be freshly worked is guided through three chucks (8, 7, 6) and the abovementioned method steps are repeated.

11. A method according to claim 10,
**characterised in that**
the wire region guided from the third chuck (8) is demagnetized.

12. A method according to claim 10 or 11,
**characterised in that**
the tensile force of the wire (3) is detected in the first and/or second wire region, in particular by means of a tensile force sensor (16).

13. A method according to claim 10, 11 or 12,
**characterised in that**
values of physical parameters, in particular values of electrical and magnetic parameters, of the wire (3) are detected, in particular by means of sensors, and dependent thereon the drives are controlled in such a manner that optimum values are automatically achieved.

## Revendications

1. Dispositif, en particulier machine de fabrication de fil Wiegand à partir d'un fil métallique (3), notamment à partir d'un fil métallique d'impulsions,
ledit dispositif comprenant un premier mandrin de serrage (6), un deuxième mandrin de serrage (7) et un troisième mandrin de serrage (8), le fil métallique (3) étant guidé à travers chacun des trois mandrins de serrage (6, 7, 8),
en particulier de façon telle que ledit fil métallique (3) puisse être relié aux trois mandrins de serrage avec verrouillage rotatif libérable, notamment relié par engagement positif aux trois mandrins de serrage, avec verrouillage rotatif libérable,
lesquels mandrins de serrage (6, 7, 8) sont espacés les uns des autres dans la direction du fil métallique, le deuxième mandrin de serrage (7) étant interposé entre les premier et troisième (8) mandrins de serrage dans la direction dudit fil métallique,
ledit deuxième mandrin de serrage (7) étant monté de manière rotative, de telle sorte qu'une première région du fil métallique puisse être sollicitée à la torsion, et qu'une seconde région dudit fil métallique puisse être sollicitée par la torsion inverse,
ladite première région du fil métallique étant située entre le premier mandrin de serrage (6) et le deuxième mandrin de serrage (7),
ladite seconde région dudit fil métallique étant située entre le troisième mandrin de serrage (8) et ledit deuxième mandrin de serrage (7),
sachant que l'espacement entre les premier et deuxième mandrins de serrage (6, 7), dans ladite direction du fil métallique, peut être commandé ou régulé au moyen d'un premier actionneur linéaire,
l'espacement entre les deuxième et troisième mandrins de serrage (8, 7), dans ladite direction du fil métallique, pouvant être commandé ou régulé au moyen d'un second actionneur linéaire.

2. Dispositif selon la revendication 1,
**caractérisé par le fait que**
les trois mandrins de serrage (8, 7, 6) sont agencés, à chaque fois, avec isolation électrique par rapport au reste dudit dispositif,
- sachant qu'une source de tension est connectée au premier mandrin de serrage (6) par son premier pôle, et au troisième mandrin de serrage (8) par son second pôle, en particulier de façon telle que les première et seconde régions du fil métallique puissent être sollicitées par du courant,
- ou sachant qu'une source de tension est connectée audit premier mandrin de serrage par son premier pôle, et au deuxième mandrin de serrage (7) par son second pôle, en particulier de façon telle que la première région du fil métallique puisse être sollicitée par du courant,
- ou bien sachant qu'une source de tension est connectée audit deuxième mandrin de serrage (7) par son second pôle, et audit troisième mandrin de serrage (8) par son second pôle, en particulier de façon telle que la seconde région dudit fil métallique puisse être sollicitée par du courant.

3. Dispositif selon l'une des revendications précédentes,
**caractérisé par le fait que**
le premier mandrin de serrage (6) est logé dans une première unité d'allongement (13),
le troisième mandrin de serrage (8) est logé dans une seconde unité d'allongement (14),
le deuxième mandrin de serrage (7) est logé dans une unité de torsion (12), avec montage rotatif.

4. Dispositif selon l'une des revendications précédentes,
**caractérisé par le fait que**
le troisième mandrin de serrage (8) peut être animé d'une rotation par un moteur électrique (9), notamment au moyen d'un entraînement par courroie de l'unité de torsion (12) qui est mené par un deuxième moteur électrique (10).

5. Dispositif selon l'une des revendications précédentes,
**caractérisé par le fait que**
la première unité d'allongement (13) peut être mue linéairement par rapport à l'unité de torsion (12), par le premier actionneur linéaire, notamment dans la direction du fil métallique ou en sens inverse de ladite direction du fil métallique ;
et/ou **par le fait que**
la seconde unité d'allongement (14) peut être mue linéairement par rapport à ladite unité de torsion (12), par le second actionneur linéaire, notamment en sens inverse de ladite direction du fil métallique ou dans ladite direction du fil métallique.

6. Dispositif selon l'une des revendications précédentes,
**caractérisé par le fait que**
le premier actionneur linéaire est pourvu d'un entraînement à broche, mené par un premier moteur électrique (9), sachant notamment que ledit premier moteur électrique (9) est relié rigidement à une platine de base (21), que l'arbre rotorique dudit moteur électrique est relié, avec verrouillage rotatif, à une broche en liaison opérante avec un écrou à broche qui est relié rigidement à la première unité d'allongement (13), en particulier au premier mandrin de serrage (6) ;
et/ou **par le fait que**
le second actionneur linéaire est doté d'un entraînement à broche, mené par un troisième moteur électrique (11), sachant notamment que ledit troisième moteur électrique (11) est relié rigidement à ladite platine de base (21), que l'arbre rotorique dudit troisième moteur électrique (11) est relié, avec verrouillage rotatif, à une broche supplémentaire en liaison opérante avec un écrou à broche supplémentaire qui est relié rigidement à la seconde unité d'allongement (14), en particulier au troisième mandrin de serrage (8).

7. Dispositif selon l'une des revendications précédentes,
**caractérisé par le fait que**
l'unité de torsion (12), en particulier le deuxième moteur (10), est relié(e) rigidement à la platine de base (21), sachant que ledit deuxième moteur (10) mène l'entraînement à broche qui actionne le deuxième mandrin de serrage (7), et/ou imprime une rotation audit deuxième mandrin de serrage (7) en vue d'engendrer une torsion dans la région du fil métallique devant être respectivement traitée.

8. Dispositif selon l'une des revendications précédentes,
**caractérisé par le fait que**
ledit dispositif est muni d'un capteur (17, 18) affecté à la détection d'au moins une grandeur magnétique.

9. Dispositif selon l'une des revendications précédentes,
**caractérisé par le fait que**
ledit dispositif est muni d'un capteur (17, 18) affecté à la détection d'une contrainte de traction dans une région du fil métallique devant être traitée,
sachant notamment que ledit capteur (17, 18), affecté à la détection de ladite contrainte de traction, est implanté dans la (les) première et/ou seconde (14) unité(s) d'allongement.

10. Procédé d'exploitation d'un dispositif conforme à l'une des revendications précédentes,
**caractérisé par le fait que**
la région du fil métallique (3), devant être traitée, est guidée à travers trois mandrins de serrage (8),
lesquels mandrins de serrage (6, 7, 8) sont ensuite actionnés, en particulier fermés, de façon telle que le fil métallique (3) soit retenu à l'aide desdits mandrins de serrage, par engagement positif,
le deuxième mandrin de serrage (8) étant ensuite animé d'une rotation, l'axe de rotation étant orienté coaxialement à la direction dudit fil métallique,
et l'espacement entre le premier mandrin de serrage (6) et ledit deuxième mandrin de serrage (7) étant modifié, notamment agrandi, de même que l'espacement entre le troisième mandrin de serrage (8) et ledit deuxième mandrin de serrage (7) est modifié, notamment agrandi,
ledit fil métallique étant sollicité par un courant entre deux mandrins, au sein desdits mandrins de serrage (6, 7, 8), en particulier entre les premier et troisième mandrins de serrage (6, 8) ou entre les premier et deuxième mandrins de serrage (6, 7), ou bien entre lesdits deuxième et troisième mandrins de serrage (7, 8),
après quoi lesdits mandrins de serrage (8, 7, 6) sont ouverts et le fil métallique (3) est animé d'un mouvement supplémentaire, de sorte qu'une région dudit fil métallique (3), devant être de nouveau traitée, est guidée à travers trois mandrins de serrage (8, 7, 6) et les étapes opératoires précitées sont réitérées.

11. Procédé selon la revendication 10,
**caractérisé par**
une démagnétisation de la région du fil métallique extraite du troisième mandrin de serrage (8).

12. Procédé selon la revendication 10 ou 11,
**caractérisé par le fait que**
la force de traction du fil métallique (3), dans la (les) première et/ou seconde région(s) dudit fil métallique, est notamment détectée au moyen d'un capteur (16) de forces de traction.

13. Procédé selon la revendication 10, 11 ou 12,
**caractérisé par le fait que**
des valeurs de grandeurs physiques, en particulier des valeurs de grandeurs électriques et magnétiques du fil métallique (3), sont notamment déterminées au moyen de capteurs, en fonction de quoi les entraînements sont pilotés de telle sorte qu'un optimum de valeurs soit atteint en mode automatisé.
